(19) Europäisches Patentamt
European Patent Office
Office européen des brevets

(11) **EP 2 953 242 A1**

(12) **EUROPEAN PATENT APPLICATION**

(43) Date of publication:
**09.12.2015 Bulletin 2015/50**

(51) Int Cl.:
**H02K 5/15** *(2006.01)* **H02P 6/18** *(2006.01)*
**H02P 29/02** *(2006.01)* **B66B 1/00** *(2006.01)*
**G01B 7/14** *(2006.01)* **G01R 31/06** *(2006.01)*

(21) Application number: **14170727.3**

(22) Date of filing: **02.06.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Kone Corporation
00330 Helsinki (FI)**

(72) Inventors:
• **Kyöstiö, Mika
13130 Hämeenlinna (FI)**
• **Loukas, Tommi
11910 Riihimäki (FI)**

(74) Representative: **Papula Oy
P.O. Box 981
00101 Helsinki (FI)**

(54) **Axial flux permanent magnet motor condition monitoring**

(57)    Axial flux permanent magnet motor is an electric motor having high attractive force between the rotor and stator. The force causes stress and wearing to the supporting structures in the motor and in the device to where the motor has been installed to. After certain period of time these stresses and wearing can cause the air gap between the rotor and stator to be decreased and in the end it will close completely. The closure during operation of the motor will cause mechanical contact and damage to the motor. The decreased air gap between the rotor and stator can be detected from a change in the electromotive force voltage between the rotor and stator. When the change is detected the operation of the motor may be stopped and the defect can be repaired before further damage is caused.

Figure 1

EP 2 953 242 A1

**Description**

**FIELD OF THE INVENTION**

The invention relates to monitoring axial flux permanent magnet motors.

**BACKGROUND OF THE INVENTION**

Axial flux permanent magnet motors are electric motors having a high attractive force between stator and rotor. An example application of a use of such motor is an elevator, wherein an axial flux permanent magnet motor is configured to operate the elevator. The rotor-side of the electric motor is implanted to the traction sheave of the elevator and the stator side is attached to a frame such that the motor can rotate the traction sheave to the desired direction. Between the stator and rotor there is a space or air gap which allows rotating without physical contact.

**SUMMARY**

As mentioned above axial flux permanent magnet motors have a high attractive force between the stator and rotor in the direction of rotational axis, when the motor is energized. Thus, they tend to cause stress to other parts, such as bearings supporting the traction sheave and other parts that are configured to keep the stator and rotor at the distance originally designed depending on the application needs. In conventional solutions the structures have been designed in a manner that they are very strong, however the stress typically causes wearing of the support structures that will bring in some cases the stator and rotor closer to each other. The stress also grows progressively when the air gap diminishes. Eventually the air gap will close completely during the operation of the motor. Progressive change of the stress is especially high in machineries having separate motor at both sides of the rotor. In most of the cases the contact will cause damage to the motor and/or the structure comprising rotor-side. In case of elevators the mechanical contact appears typically high forces and speeds are involved, which will mean larger damage than in some other applications.

Until recently the solution of providing very strong supporting structures has omitted the problem mentioned above and it has been noticed only recently that stator or rotor can move and cause damage as discussed above. This new problem has particularly emerged in applications where two motors are located on the opposite sides of rotor. In such applications high power is needed and typically the individual motors are very powerful. In such configuration when the rotor starts to move the attractive force increases on the first side, where the gap is closing, and in the other hand decreases on the second side, where the gap is open-ing. Thus, this will cause bigger attractive force as designed on the first side and eventually this will lead into gap closure.

As the problem is not known before the prior art does not provide any other solution to this problem than manual inspection, however, the motors are typically closed and the maintenance person cannot see inside the motor and thus cannot see if the gap is closing.

Axial flux permanent magnet motor, as mentioned above, is an electric motor having high attractive force between the rotor and stator. The force causes stress and wearing to the supporting structures in the motor and in the device to where the motor has been installed to. After certain period of time these stresses and wearing can cause the air gap between the rotor and stator to be decreased and in the end it will close completely. The closure during operation of the motor will cause mechanical contact and damage to the motor. The decreased air gap between the rotor and stator can be detected from a change in the electromotive force voltage between the rotor and stator. When the change is detected the operation of the motor may be stopped and the defect can be repaired before further damage is caused.

In an embodiment of the invention a method for detecting a change in the air gap between a stator and rotor in a permanent magnet axial flux permanent magnet motor is disclosed. In the method emf-voltage in the coils of the stator is monitored. Then the monitored emf-voltage is compared with a reference voltage. As a result of the comparison a change in the air gap between the stator and rotor when the monitored emf-voltage is different than the reference voltage is detected. In a further embodiment the monitoring of voltage in the coil of the stator firts stator voltage and current and rotor frequency are determined and then the emf-voltage is calculated using said determined stator voltage, current and rotor frequency. Determining the stator voltage and current may be done by receiving the stator voltage and current from a frequency converter. The rotor frequency may be determined by receiving the rotor frequency from a device connected monitor the frequency of said rotor.

When a change in the air gap is detected the the axial flux permanent magnet motor may be stopped and/or launch an alarm.

In an embodiment of the invention the method disclosed above is implemented as a computer program that is configured to cause the method disclosed above when executed on a data-processing system.

In an embodiment of the invention the invention is implemented as an apparatus comprising at least one input for receiving stator voltage and current from said axial flux permanent magnet motor and rotor frequency from a device measuring rotor frequency, at least one processor, wherein the processor is configured to: monitor emf-voltage in the coils of said stator, compare said calculated emf-voltage with a reference voltage; and detect a change in said air gap between the stator and rotor when said monitored emf-voltage is different than said reference voltage.

The benefit of the invention is the possibility to detect the decreased distance between rotor and stator before the closure of the air gap. This facilitates repairing the breaking parts before they cause further damage to the axial flux permanent magnet motor used. This leads to savings as especially in installations where powerful motors are used as big installations involve typically expensive motors that are in many cases completely destroyed and need to be changed after the mechanical contact that has occurred during operating the motor at high speed. In addition to the cost savings a benefit of the invention is that the out of order time of the application using such motor is reduced which will lead into improved service.

**BRIEF DESCRIPTION OF THE DRAWINGS**

The accompanying drawings, which are included to provide a further understanding of the invention and constitute a part of this specification, illustrate embodiments of the invention and together with the description help to explain the principles of the invention. In the drawings:

>     **Fig. 1** is a block diagram of an example embodiment of the present invention, and
>     **Fig. 2** is a flow chart of a method according to the present invention.

**DETAILED DESCRIPTION OF THE INVENTION**

Reference will now be made in detail to the embodiments of the present invention, examples of which are illustrated in the accompanying drawings.

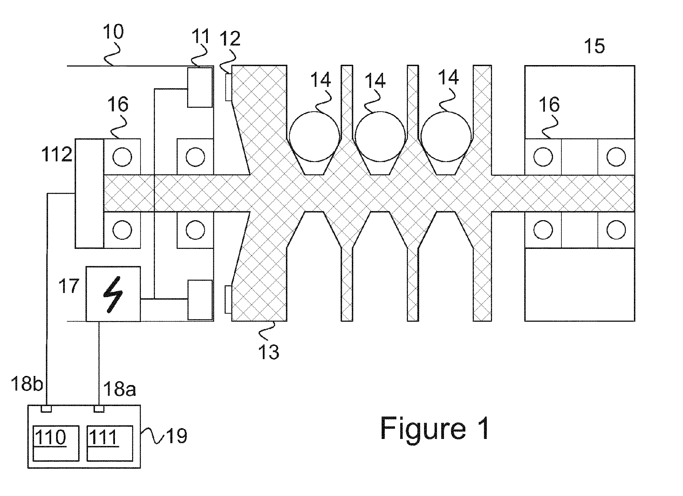

In figure 1 a block diagram of an example embodiment of the present invention is disclosed. In the figure an axial flux permanent magnet motor 10 is used for driving an elevator. Stator 11 coils are located in the motor 10 side and rotor 12 magnets are attached to a traction sheave 13, which is operating ropes 14 of the elevator. The traction sheave is supported by bearings 16 on both sides of the traction sheave 13. In the example embodiment of the figure a support 15 is in the other end of the traction sheave axel, however, also other configurations are possible. Especially in high-power solutions electric motors are located on both sides of the traction sheave and constructions where the other end of the axel is unsupported.

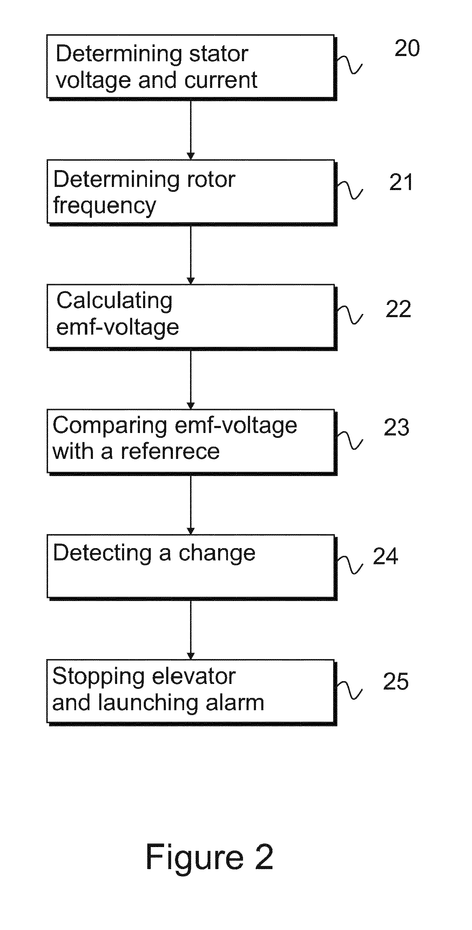

The problem in the construction described above is that the attractive force between stator 11 and rotor 12 tries to close the air gap between stator 11 and rotor 12. When the gap is closed and the rotor 12 is rotating the mechanical contact will in most cases break the electric motor. The bigger power is needed for operating the elevator the bigger damage typically caused is. In the arrangement of figure 1 the problem is solved such that the electricity supply 17, such as frequency converter is connected an apparatus 19 for monitoring the electromotive force voltage between stator and rotor. The apparatus is configured to receive the current and voltage information from the electricity supply by using input 18a. In addition to the electricity information the apparatus 19 is connected to a device 112 measuring the rotor frequency by using input 18b. The device 112 can be for example a device that is used for determining the speed of the elevator and thus it measures the rotating speed of the traction sheave. From this information the apparatus 19 can calculate the electromotive force voltage as described later with referral to figure 2 by using processor 110 and memory 111. When an unallowed deviation from correct electromotive force voltage is detected it can be concluded that the air space in between has changed.

In figure 2 a method according to the present invention is disclosed. The method is initiated by monitoring the voltage and current in stator coil, step 20. The monitoring may be done by using any suitable voltage and current meters. Then the rotor frequency is determined, step 21. The rotor frequency may be measured, for example, by determining the rotating speed of the traction sheave to which rotors are attached to. If the invention is not used with elevators but with other applications, the rotation speed of the axel may be measured correspondingly.

The following calculation is based on the fact that the equations may be simplified when the current vector rotates in d,q coordinate system in constant speed, which can be assumed when changes in speed are slow compared to the L/R-timing constant of the stator coils. The emf-voltage may be calculated, step 22, in d, q coordinate system fixed to the rotor, and thus rotating with the rotor, as follows:

$$E_d = U_d - wLI_q$$

$$E_q = U_q - RI_q$$

When $I_d = 0$, and rotating velocity is constant w. Motor inductance is L and stator coil resistance is R. Stator voltage has $U_d$, Uq vector components and stator current has $I_d$, Iq vector components in the rorating d,q coordinate system.

The calculated emf-voltage is then compared with a reference value, step 23. The reference value $R_{EMF}$ also changes as a function of rotation speed of the electric motor:

$$R_{EMF} = K * w$$

Wherein K is a constant that is determined by measuring from the motor when it is working normally. If more accurate estimate is needed then more variables, such as the operating temperature, may be taken into account, for example, by measuring the value of K in different operating temperatures. If a simpler embodiment desired, an elevator the motor is typically driven at full speed and the reference value may be a constant value that is compared with the calculated emf-voltage when the elevator is running full speed If the calculated value does not match with the reference value within an acceptable tolerance a change is detected, step 24. The comparison does not need to provide exactly the same value but small inaccuracy is accepted. The level of accepted tolerance is set on application basis.

When a change has been detected the elevator may be stopped and a message to the maintenance center will be sent, step 25. In a further embodiment there may be two different reference values. Exceeding the first the message will be send and exceeding the second will stop the elevator. Before stopping the service the elevator may be brought to the next floor in order to let the passengers out.

In some embodiments, after detection of failure elevator operation may be continued with reduced speed/acceleration until maintenance personnel arrive.

The above embodiment and respective method involves an example having one electric motor in an elevator application. The method works without modifications also in other applications involving an axial flux permanent magnet motor. Furthermore, in more power demanding applications, such as high-rise elevators, two electric motors may be used in opposite sides of rotor. Thus, it is possible that if the air gap is closing on one side, it will be opening on the other side. In this case the resultant of axial force affecting on traction sheave support will increase more rapidly as the failure proceeds. This is because in normal operation the reverse axial attraction force components of the separate motors at least mostly void each other. The method according to the present invention will detect the change also in those cases where the air gap is opening.

A person skilled in the art understands that the method described above is executed continuously when the electric motor is operated. Thus, steps 20 - 24 may be and typically are executed simultaneously and if a change is detected then the method is stopped together with the elevator in step 25.

The above mentioned method may be implemented as computer software which is executed in a computing device able to communicate with a mobile device. When the software is executed in a computing device it is configured to perform the above described inventive method. The software is embodied on a computer readable medium so that it can be provided to the computing device, such as the apparatus 19 of figure 1.

As stated above, the components of the exemplary embodiments can include computer readable medium or memories for holding instructions programmed according to the teachings of the present inventions and for holding data structures, tables, records, and/or other data described herein. Computer readable medium can include any suitable medium that participates in providing instructions to a processor for execution. Common forms of computer-readable media can include, for example, a floppy disk, a flexible disk, hard disk, magnetic tape, any other suitable magnetic medium, a CD-ROM, CD±R, CD±RW, DVD, DVD-RAM, DVD±RW, DVD±R, HD DVD, HD DVD-R, HD DVD-RW, HD DVD-RAM, Blu-ray Disc, any other suitable optical medium, a RAM, a PROM, an EPROM, a FLASH-EPROM, any other suitable memory chip or cartridge, a carrier wave or any other suitable medium from which a computer can read.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A method for detecting a change in the air gap between a stator and rotor in an permanent magnet axial flux permanent magnet motor, which method comprises:

    monitoring emf-voltage in the coils of said stator;
    comparing said monitored emf-voltage with a reference voltage;
    detecting a change in said air gap between the stator and rotor when said monitored emf-voltage is different than said reference voltage.

2. The method according to claim 1, wherein said monitoring voltage in the coils of said stator comprises:

    determining stator voltage and current;
    determining rotor frequency;
    calculating said emf-voltage using said determined stator voltage, current and rotor frequency.

3. The method according to claim 2, wherein determining said stator voltage and current by receiving said stator voltage and current from a frequency converter.

4. The method according to claim 2 or 3, wherein determining said rotor frequency by receiving said rotor frequency from a device connected monitor the frequency of said rotor.

5. The method according to any of preceding claims 2 - 4, wherein the method further comprises stopping said axial flux permanent magnet motor and/or launching an alarm when a change in said air gap is detected.

6. A computer program for a server comprising code adapted to cause the following method according to any of claims 1 - 5 when executed on a data-processing system.

7. An apparatus for detecting a change in the air gap between a stator and rotor in n axial flux a permanent magnet motor comprising:

   at least one input for receiving stator voltage and current from said axial flux permanent magnet motor and rotor frequency from a device measuring rotor frequency;
   at least one processor;

   wherein said processor is configured to:

   monitor emf-voltage in the coils of said stator;
   compare said calculated emf-voltage with a reference voltage; and
   detect a change in said air gap between the stator and rotor when said monitored emf-voltage is different than said reference voltage.

8. The apparatus according to claim 7, wherein when monitoring emf-voltage the apparatus is configured to:

   determine stator voltage and current;
   determine rotor frequency; and
   calculate said emf-voltage using said determined stator voltage, current and rotor frequency.

9. The apparatus according to claim 8, wherein the apparatus is coupled to frequency converter and configured to determine said stator voltage and current by receiving said stator voltage and current from said frequency converter.

10. The apparatus according to claim 8 or 9, wherein the apparatus is coupled to a rotor frequency measurement device and configured to determine said rotor frequency by receiving said rotor frequency from a device.

11. The apparatus according to any of preceding claims 7 - 10, wherein the apparatus is further configured to stop said axial flux permanent magnet motor and/or launch an alarm when a change in said air gap is detected.

12. An elevator comprising the apparatus according to any preceding claims 7 - 11.

13. An elevator according to claim 12, wherein said elevator comprises two axial flux permanent magnet motors arranged to opposite sides of the traction sheave.

Figure 1

Figure 2

Europäisches
Patentamt

European
Patent Office

Office européen
des brevets

# EUROPEAN SEARCH REPORT

Application Number

EP 14 17 0727

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SU 1 740 986 A1 (MO I INZH SELSKOKHOZYAJS [SU]) 15 June 1992 (1992-06-15) | 1,5-7,11 | INV. H02K5/15 |
| Y | * column 4; figures 1-4 *<br>* abstract * | 2-4, 8-10,12, 13 | H02P6/18 H02P29/02 B66B1/00 G01B7/14 |
| Y | JP 2003 199390 A (TOSHIBA CORP) 11 July 2003 (2003-07-11) * paragraph [0003] - paragraph [0005] * | 2-4,8-10 | G01R31/06 |
| A | US 2012/262095 A1 (SMITH JAMES S [US] ET AL) 18 October 2012 (2012-10-18) * paragraph [0003] * | 5,11 | |
| Y | FICHEUX R ET AL: "Axial-flux permanent-magnet motor for direct-drive elevator systems without machine room", INDUSTRY APPLICATIONS CONFERENCE, 2000. CONFERENCE RECORD OF THE 2000 IEEE 8-12 OCTOBER 2000, PISCATAWAY, NJ, USA,IEEE, vol. 1, 8 October 2000 (2000-10-08), pages 190-197, XP010521207, ISBN: 978-0-7803-6401-1 * abstract * | 12,13 | |

TECHNICAL FIELDS SEARCHED (IPC)

H02K
H02P
B66B
G01B
G01R

The present search report has been drawn up for all claims

| Place of search | Date of completion of the search | Examiner |
|---|---|---|
| Munich | 6 November 2014 | Schürle, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 17 0727

This annex lists the patent family members relating to the patent documents cited in the above-mentioned European search report.
The members are as contained in the European Patent Office EDP file on
The European Patent Office is in no way liable for these particulars which are merely given for the purpose of information.

06-11-2014

| Patent document cited in search report | | | Publication date | Patent family member(s) | | | Publication date |
|---|---|---|---|---|---|---|---|
| SU 1740986 | A1 | | 15-06-1992 | NONE | | | |
| JP 2003199390 | A | | 11-07-2003 | JP | 4154149 | B2 | 24-09-2008 |
| | | | | JP | 2003199390 | A | 11-07-2003 |
| US 2012262095 | A1 | | 18-10-2012 | CN | 103703658 | A | 02-04-2014 |
| | | | | EP | 2697893 | A2 | 19-02-2014 |
| | | | | US | 2012262095 | A1 | 18-10-2012 |
| | | | | US | 2013119802 | A1 | 16-05-2013 |
| | | | | WO | 2012142230 | A2 | 18-10-2012 |

EPO FORM P0459

For more details about this annex : see Official Journal of the European Patent Office, No. 12/82